# EUROPEAN PATENT APPLICATION

(11) **EP 4 386 857 A1**
(43) Date of publication of application: **19.06.2024**
(21) Application number: 23215067.2
(22) Date of filing: 07.12.2023
(51) Int. Cl.: H01L 29/747, H01L 29/06, H01L 21/332, H01L 29/423

(54) **A TRIAC DEVICE WITH HIGH COMMUTATING CAPABILITY**

(30) Priority: 15.12.2022 CN 202211616875
(71) Applicant: Littelfuse Semiconductor (Wuxi) Co., Ltd., Wuxi, Jiangsu 214142 (CN)
(72) Inventor: Zhou, Jifeng, Wuxi 214142 (CN); Zhang, Glenda, Wuxi 214142 (CN); He, Lei, Wuxi 214142 (CN)
(74) Representative: Arnold & Siedsma

(57) **Abstract**

A semiconductor device apparatus, structure and associated methods thereof. The apparatus includes a first silicon layer, a second silicon layer, and a third silicon layer, the first silicon being coupled to the second silicon layer and the second silicon layer being coupled to the third silicon layer. The apparatus includes a trench formed in the first silicon layer and in at least a portion of the second silicon layer, an isolation region formed in at least the second silicon layer, where the isolation region extends from the trench to the third silicon layer. The apparatus also includes a first main terminal one and a first gate terminal coupled to a first portion of the first silicon layer, a second main terminal one and a second gate terminal coupled to a second portion of the first silicon layer, a main terminal two coupled to the third silicon layer, and one or more silicon regions in the first silicon layer and in the third silicon layer.

## Description

### TECHNICAL FIELD

This disclosure relates generally to the field of solid state current controlling devices, and in particular, to thyristor devices, and more particularly to triode for alternating current (TRIAC) devices.

### BACKGROUND

Modern electronics rely on a semiconductor devices diodes for a variety of functions, including, for example, conducting currents in various directions. Such devices are manufactured using n-type and p-type semiconductor materials and may include thyristor semiconductor devices, such as, for example TRIAC semiconductor devices, and/or any other type of devices. During manufacture of such devices, a semiconductor substrate having a conductivity of a first type is exposed to implantation, diffusion, or deposition of species of a second type, including epitaxial growth of a layer having species of the second type. After the species of the second type is provided, annealing may be performed to diffuse and activate the species of second conductivity type. Existing TRIAC semiconductor device include a single gate providing a single gate control for triggering conduction of current in all quadrants of the TRIAC semiconductor device. However, such device suffer from low commutability and operational deficiency.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

The current subject matter relates to a semiconductor device apparatus. The apparatus may include a first silicon layer, a second silicon layer, and a third silicon layer, the first silicon being coupled to the second silicon layer and the second silicon layer being coupled to the third silicon layer. The apparatus may include a trench formed in the first silicon layer and in at least a portion of the second silicon layer, an isolation region formed in at least the second silicon layer, where the isolation region extends from the trench to the third silicon layer. The apparatus may also include a first main terminal one and a first gate terminal coupled to a first portion of the first silicon layer, a second main terminal one and a second gate terminal coupled to a second portion of the first silicon layer, a main terminal two coupled to the third silicon layer, and one or more silicon regions in the first silicon layer and in the third silicon layer.

The current subject matter may include one or more of the following optional features. At least one of the first, second and third silicon layers may be at least one of the following: an n-type layer, a p-type layer, and any combination thereof. The first silicon layer and the third silicon layers may be p-type layers, and the second silicon layer may be an n-type layer. The first and third silicon layers may be P+ layers. The second silicon layer maybe a N- layer. One or more silicon regions may be n-type regions.

The isolation region may be a p-doped region.

The trench may be configured to separate the first silicon layer into the first portion of the first silicon layer and the second portion of the first silicon layer. The trench and the isolation region may be configured to separate the apparatus into a first apparatus portion and a second apparatus portion. The first main terminal one and the first gate terminal may each be coupled to at least one region in the one or more regions. The second gate terminal may be coupled to at least another region in the one or more regions and the second main terminal one is not coupled to the one or more regions. The main terminal two may be coupled to at least yet another region in the one or more regions, where such region may be positioned in the third silicon layer in the second apparatus portion.

A depth of the trench may be configured to be greater than a thickness of the first silicon layer.

The trench and the isolation region may be configured to prevent migration of one or more charge carriers between the first and second apparatus portions. The first apparatus portion may be configured to route current upon a bias of main terminal two being higher than a bias of the first main terminal one. The second apparatus portion may be configured to route current upon a bias of the second main terminal one being higher than a bias of the main terminal two.

The apparatus may be a semiconductor device. The semiconductor device may be a thyristor. The semiconductor device may be a TRIAC semiconductor device.

The current subject matter relates to a semiconductor device. The semiconductor device may include a first silicon layer, a second silicon layer, and a third silicon layer, the first silicon being coupled to the second silicon layer and the second silicon layer being coupled to the third silicon layer. The semiconductor device may include a trench formed in the first silicon layer and in at least a portion of the second silicon layer, an isolation region formed in at least the second silicon layer, where the isolation region extends from the trench to the third silicon layer. The trench and the isolation region may be configured to separate the semiconductor device into a first semiconductor device portion and a second semiconductor device portion. The semiconductor device may also include a first main terminal one and a first gate terminal coupled to a first portion of the first silicon layer, a second main terminal one and a second gate terminal coupled to a second portion of the first silicon layer, a main terminal two coupled to the third silicon layer, and one or more silicon regions in the first silicon layer and in the third silicon layer. The first semiconductor device portion may be configured to route current upon a bias of main terminal two being higher than a bias of the first main terminal one, and the second semiconductor device portion may be configured to route current upon a bias of the second main terminal one being higher than a bias of the main terminal two.

The current subject matter relates to a method for manufacturing a semiconductor device. The method may include providing a first silicon layer, a second silicon layer, and a third silicon layer; coupling the first silicon to the second silicon layer and coupling the second silicon layer to the third silicon layer; forming a trench in the first silicon layer and at least a portion of the second silicon layer; forming an isolation region in at least the second silicon layer, wherein the isolation region is configured to extend from the trench to the third silicon layer; coupling a first main terminal one and a first gate terminal to a first portion of the first silicon layer, coupling a second main terminal one and a second gate terminal to a second portion of the first silicon layer, and coupling a main terminal two to the third silicon layer; and forming one or more regions in the first and second portions of the first silicon layer and the third silicon layer.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the present disclosure. In the drawings,
FIG. 1 illustrates an exemplary semiconductor device;
FIG. 2 illustrates an exemplary semiconductor device;
FIG. 3 illustrates an exemplary semiconductor device, according to the present disclosure; and
FIG. 4 illustrates an exemplary process, according to the present disclosure .

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings.

To address these and potentially other deficiencies of currently available solutions, relates to methods, systems, articles of manufacture, and the like that can, among other possible advantages, provide a solid state current controlling device, and in particular, to a thyristor device, and more particularly a triode for alternating current (TRIAC) device having a high commutating capability.

Current controlling devices, such as, for example, thyristors, refer to a solid-state semiconductor devices having four layers of alternating p-type and n-type materials. In some cases, thyristors are used in high-power applications bistable switches configured to conduct current when a gate of the thyristor receives a current trigger, and continue to conduct until the voltage across the device is reverse-biased, or until the voltage is no longer applied. Thyristors typically come in two-lead and three-lead configurations. In two-lead configurations, current is conducted when a potential different between anode and cathode terminals is large enough (i.e., equal to a breakdown voltage). In the three-lead configuration, a small current on thyristor's gate terminal controls the current (a larger current) between anode and cathode.

TRIACs are a type of thyristors. They allow current to flow in both directions (e.g., anode to cathode and cathode to anode), unlike another type of thyristors - silicon control rectifiers (SCRs). A TRIAC can be triggered through application of either a positive or a negative voltage to the TRIAC's gate terminal and can continue to conduct current, even if the current on the gate terminal is no longer present, until the main current falls below a holding current.

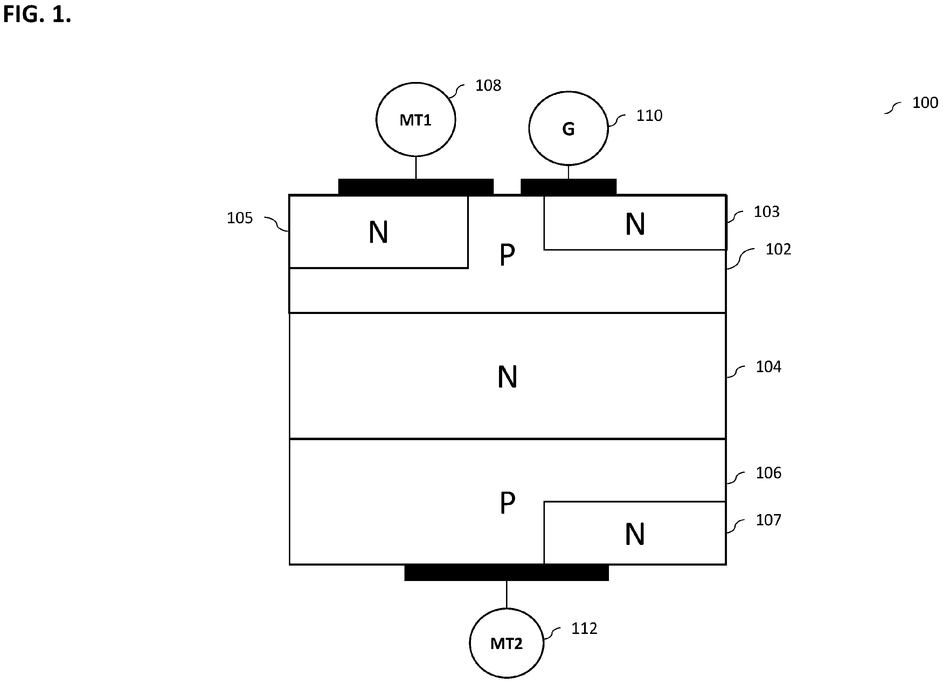

FIG. 1 illustrates an exemplary semiconductor device 100. The semiconductor device 100 can be a TRIAC device and can include a p-type layer 102, a n-type layer 104, and a p-type layer 106. The layer 102 may be configured to include a first n-type region 103 and a second n-type region 105. Similarly, layer 106 may be configured to include a third n-type region 107. The device 100 also includes a first main terminal (MT1) or an anode 1 (used interchangeably herein) 108, a gate terminal 110, and a second main terminal (MT2) or anode 2 (used interchangeably herein) 112. The first main terminal (MT1) 108 is coupled to a portion of the layer 102 and a portion of the second n-type region 105. The gate terminal 110 is coupled to another portion of the layer 102 and a portion of the first n-type region 103. The second main terminal (MT2) 112 is coupled to a portion of the layer 106 and a portion of the third n-type region 107.

The device 100 operates using one of the four combinations or quadrants of triggering voltages across the gate 110 and MT2 112 terminals with respect to the MT1 108 terminal. In the first combination, the gate 110 and MT2 112 are positive with respect to MT1 108; in the second combination, the gate 110 is negative and MT2 112 is positive with respect to MT1 108; in the third combination, the gate 110 and MT2 112 are negative with respect to MT1 108; and in the fourth combination, the gate 110 is positive and MT2 is negative with respect to MT1 108.

In the first and second combinations, since MT2 112 is positive, the current flows from MT2 112 to MT1 108 through p-type layer 106, n-type layer 104, p-type layer 102 and n-type region 105. The n-type region 107 in the p-type layer 106 and attached to MT2 112 is not involved.

In the third and fourth combinations, since MT2 112 is negative, the current flows from MT1 108 to MT2 112 through p-type layer 102, n-type region 103, n-type layer 104, and p-type layer 106. The n-type region 107 in the p-type layer 106 and attached to MT2 112 is active. The n-type region 105 in the p-type layer 102 and attached to MT1 108 only participates in the initial triggering, not the main current flow.

It should be noted for most implementations of a TRIAC, first and third combinations are the typical operational modes as the gate current comes from MT2 112 (both gate 110 and MT2 112 positive or negative against MT1 108). Other TRIAC implementations include single polarity triggering from an external circuitry (e.g., integrated circuit, digital drive circuit, etc.) and thus, involve second and third implementations, i.e., MT1 108 is connected to a positive voltage and the gate 110 is connected to the ground.

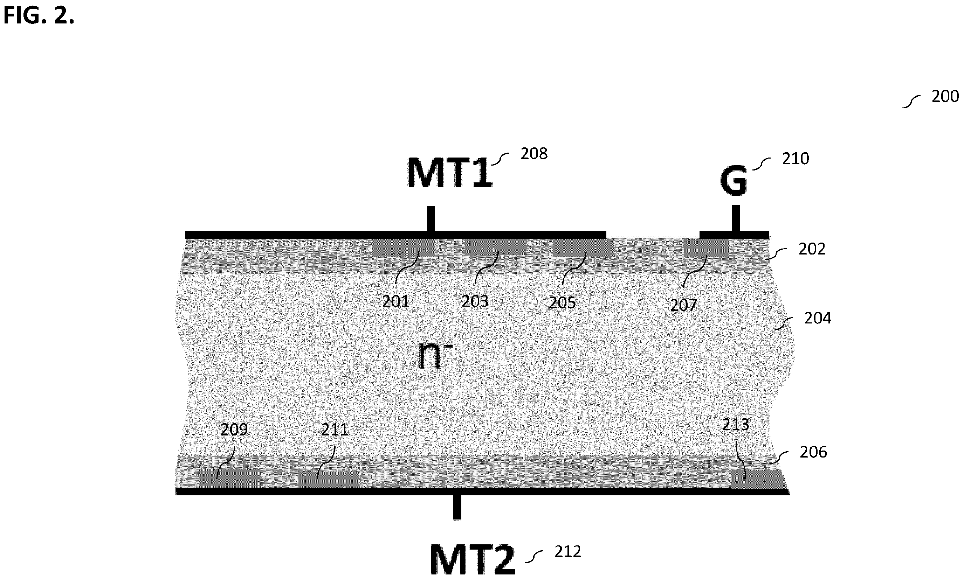

FIG. 2 illustrates an exemplary TRIAC semiconductor device 200. The device 200 includes a p-type layer 202, a n-type layer 204, and a p-type layer 206. The p-type layer 202 can include a plurality of n-type regions, such as, for example, a first n-type region 201, a second n-type region 203, a third n-type region 205, and a fourth n-type region 207. Similarly, the layer 206 can also include a plurality of n-type regions, such as, for example, a fifth n-type region 209, a sixth n-type region 211, and a seventh n-type region 213.

The device 200 also includes a first main terminal (MT1) or an anode 1 (used interchangeably herein) 208, a gate terminal 210, and a second main terminal (MT2) or anode 2 (used interchangeably herein) 212. MT1 208 is coupled to a portion of the p-type layer 202 as well as across several n-type regions, in particular, n-type region 201, n-type region 203, and n-type region 205. As shown in FIG. 2, MT1 208 is coupled to a portion of the n-type region 205, while n-type regions 201 and 203 are entirely coupled to MT1 208.

The gate terminal 210 is coupled to another portion of the p-type layer 202 as well as a portion of the n-type region 207. MT2 212 is coupled to the p-type layer 206 as well as the n-type regions, and in particular, n-type region 209, n-type region 211, and n-type region 213. The positioning and the number of the n-type regions in each of the respective layers 202 and 206 can depend on a particular application and/or expected performance characteristics of the device 200.

Similar to the device 100 shown in FIG. 1, the device 200 operates using one of the four combinations for triggering voltages across the gate 210 and MT2 112 in relation to MT1 208. The combinations are as follows: gate 210 and MT2 212 are positive; gate 210 is negative and MT2 212 is positive; gate 210 and MT2 212 are negative; and gate 210 is positive and MT2 is negative.

In the first two combinations, since MT2 212 is positive, the current flows from MT2 212 to MT1 208 through p-type layer 206, n-type layer 204, p-type layer 202 as well as one or more of the n-type regions 201-205. The one or more of the n-type regions 209-213 in the layer 206 and attached to MT2 212 might not be involved. In the last two combinations, MT2 112 is negative and the current flows from MT1 208 to MT2 212 through p-type layer 202, n-type region 207, n-type layer 204, and p-type layer 206. One or more of the n-type regions 209-213 in the p-type layer 206 and attached to MT2 212 become active. One or more of the n-type regions 201-207 in the p-type layer 202 and attached to MT1 208 can be involved during initial stages but not in the principal current flow. However, the TRIAC device 200 is designed to provide only a single gate control for triggering current in all operational combinations or quadrants of the TRIAC. No commutating capability is afforded by the TRIAC device 200.

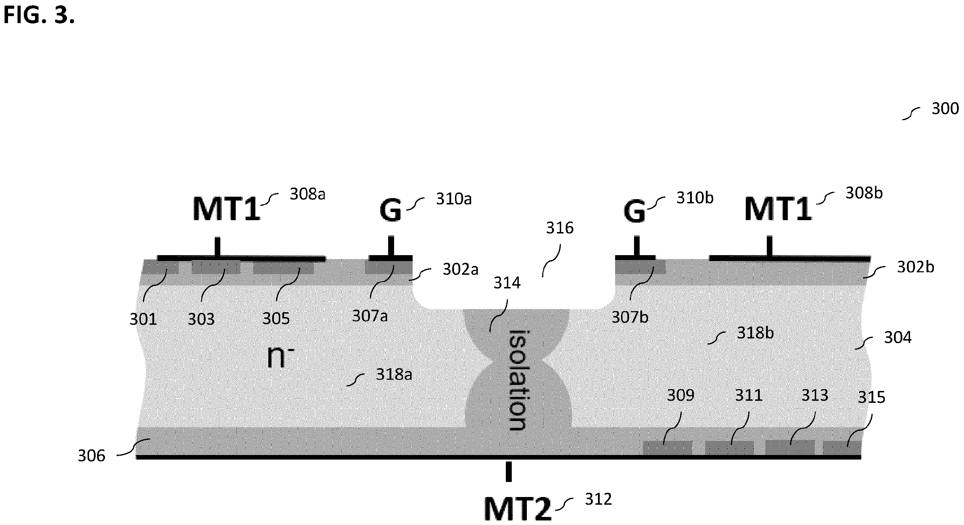

FIG. 3 illustrates an exemplary semiconductor device 300, according to the present disclosure. The device 300 may be a TRIAC device and/or any other type of thyristor.

The device 300 may be configured to include a first p-type layer 302a, a second p-type layer 302b, a n-type layer 304 (e.g., N- layer), and a p-type layer 306. The p-type layers 302 (a, b) may include a plurality of n-type regions. A first n-type region 301, a second n-type region 303, a third n-type region 305, and a fourth n-type region 307a may be disposed within the first p-type layer 302a. A firth n-type region 307b may be disposed within the second p-type layer 302b. The layer 306 may be configured to include a plurality of n-type regions, such as, for example, a sixth n-type region 309, a seventh n-type region 311, an eight n-type region 313, and a ninth n-type region 315. By way of a non-limiting example, regions 301-305 and 309-315 may be N+ type regions.

The device 300 may further include a first main terminal (MT1) 308a, a gate terminal 310a, another gate terminal 310b, another first main terminal (MT1) 308b, and a second main terminal (MT2) 312. MT1 308a may be configured to be coupled to one or more portions of the p-type layer 302a as well as across n-type region 301, n-type region 303, and n-type region 305. MT1 308a may be coupled to a portion of the n-type region 301, while n-type regions 303 and 305 are entirely coupled to MT1 308a. The other MT1 308b may be configured to be coupled to a portion of the p-type layer 302b without being coupled to any n-type regions that may be disposed within the p-type layer 302b.

The gate terminal 310a may be coupled to at least a portion of the n-type region 307a that may be disposed within the p-type layer 302a. Similarly, the gate terminal 210b may be coupled to at least a portion of the n-type region 307b that may be disposed within the p-type layer 302b.

The terminal MT2 312 may be configured to be coupled to the p-type layer 306 as well as the n-type regions 309, 311, 313, and 315. As shown in FIG. 3, MT2 312 may be configured to span the entire p-type layer 306 as well as the n-type regions 309-315.

The device 300 may further include a trench 316 and an isolation region 314. The isolation region may be configured to be disposed beneath the trench 316. The trench 316 may be configured to provide a separation between the gate terminals 310a and 310b and create a split between the p-type layers 302a and 302b as well as an upper portion of the n-type layer 304. As shown in FIG. 3, the trench 316 may be configured to have a depth that may be greater than the thickness of the p-type layers 302a and 302b and may be further configured to extend into at least a portion of the n-type layer 304. The trench 316 may have any desired shape, depth, form, size, and/or any other dimensions.

The isolation region 314 may be configured to extend between a bottom surface of the trench 316 and the p-type layer 306. The isolation region 314 may be an n-type and/or a p-type region and/or any other type of region. The isolation region 314 may be configured to be separate from the layer 306. Alternatively, or in addition, the isolation region 314 may be configured to form a unitary structure with the layer 306 and may be configured to extend from the layer 306 toward the trench 316. The isolation region 314 may have any desired shape, depth, form, size, and/or any other dimensions.

The isolation region 314 and the trench 316 may be configured to separate the device 300 into two separate portions 318a and 318b. The portion 318a may be configured to include the p-type layer 302a, a portion of the n-type layer 304 (e.g., a left-side portion of the layer 304 as shown in FIG. 3), a portion of the p-type layer 306, as well as n-type regions 301, 303, 305, and 307a disposed within the layer 302a. No n-type regions that are disposed within the p-type layer 306 are configured to be positioned within the portion 318a. Moreover, the terminal MT1 308a and the gate 310a may also be disposed in the portion 318a.

The portion 318b may be configured to include the p-type layer 302b, another portion of the n-type layer 304 (e.g., a right-side portion of the n-type layer 304, as shown in FIG. 3), a portion of the p-type layer 306, as well as n-type region 307b disposed within the layer 302b, and n-type regions 309, 311, 313, and 315. The terminal MT1 308b and the gate 310b may also be disposed in the portion 318b. The n-type regions 309-315 may be disposed directly beneath the terminal MT1 308b and the gate 310b.

Separation of the device 300 into two portions 318a and 318b using the trench 316 and the isolation region 314 may be configured to increase device 300's commutating capability. In particular, the portion 318a may be configured to be operating when a bias of the terminal MT2 312 is higher than the bias of the terminal MT1 308a. Moreover, the portion 318b may be configured to be operating when the bias of the terminal MT1 308b is higher than the bias of the terminal MT2 312. The trench 316 and the isolation region 314 may be configured to prevent migration of carriers between the portions 318 (a, b), thereby increasing device 300's commutating capability. As can be understood, the positioning and the number of the n-type regions in each of the respective layers 302 and 306 can depend on a particular application and/or expected performance characteristics of the device 300.

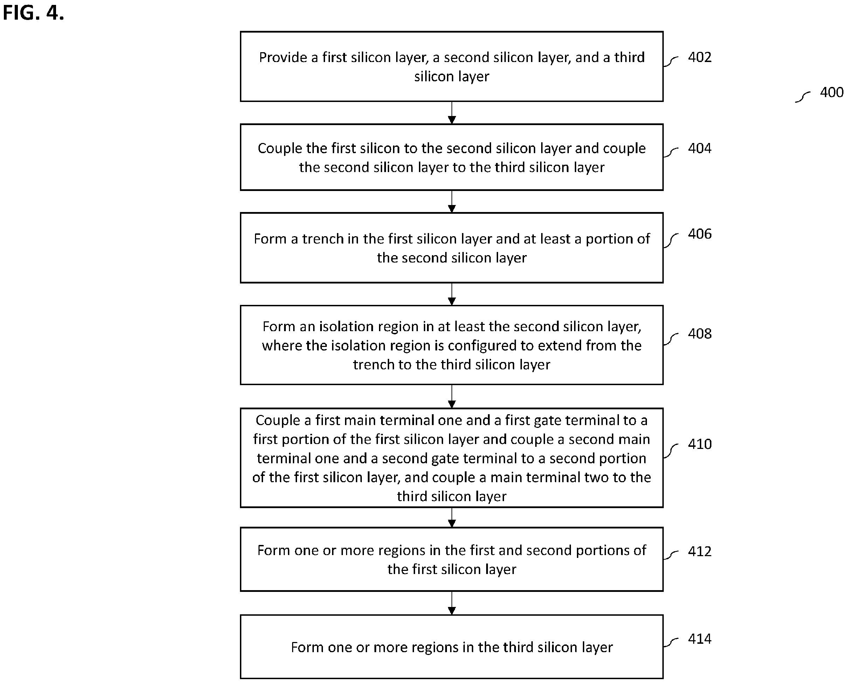

FIG. 4 illustrates an exemplary process 400 for manufacturing a semiconductor device, according to the present disclosure. The process 400 may be used to manufacture device 300 shown in FIG. 3. The process 400 may be used to manufacture a thyristor, such as, for example, a TRIAC semiconductor device.

At 402, a first silicon layer (e.g., p-type layer(s) 302), a second silicon layer (e.g., n-type layer 304), and a third silicon layer (e.g., p-type layer 306) may be provided. As stated above, the first, second, and third silicon layers may be p-type layers, n-type layers, and/or any other type layers. The first silicon layer may be initially provided as a unitary layer and may then be split using a trench, as described herein, into one or more portions 302a and 302b, as shown in FIG. 3. Alternatively, or in addition, two separate silicon layers 302a and 302b may be provided for coupling to the second silicon layer, e.g., silicon layer 304.

At 404, the first silicon layer may be coupled to the second silicon layer and the second silicon layer may be coupled to the third silicon layer. The coupling of silicon layers may be achieved using any known techniques. As shown in FIG. 3, the layers 302a and 302b may be coupled to the layer 304, and the layer 304 may be coupled to the layer 306.

At 406, a trench may be formed in the first silicon layer and at least a portion of the second silicon layer. For example, a trench 316 may be used to separate portions 302a and 302b of the first silicon layer. The depth of the trench 316 may be greater than the thickness of the first silicon layer, thereby providing isolation of any terminals (and hence, current routing during operation) at the top of the semiconductor device 300. The trench 316 may also be configured to extend into the second silicon layer 304. The trench 316 may have any desired width, form, shape, size, and/or any other dimensions.

At 408, an isolation region may be formed in at least the second silicon layer. The isolation region may be configured to extend from the trench to the third silicon layer. As shown in FIG. 3, the isolation region 314 may be configured to extend from the a bottom edge of the trench 316 to the third layer 306. The isolation region 314 may be configured to be p-doped. As can be understood, any other type of doping (and/or no doping) may be used. The isolation region 314 may have any desired width, form, shape, size, and/or any other dimensions. As stated above, the isolation region 314 along with the trench 316 may be configured to provide isolation between terminals (e.g., MT1 terminals 308 (a, b) and gate terminals 310 (a, b)), and thus, how current may be routed in one or more of the above operational combinations/quadrants.

As shown in FIG. 3, the trench 316 and the isolation region 314 may be configured to partition layers 302 and 304, and hence, the semiconductor device 300 into two separate portions - a first portion 318a and a second portion 318b. Each portion 318 may be coupled to its own set of MT1 and gate terminals 308, 310 and both may be coupled to a single MT2 terminal 312. As shown in FIG. 3, the portion 318a may be coupled to MT1 terminal 308a and gate terminal 310a, and portion 318b may be coupled to MT1 terminal 308b and gate terminal 310b.

At 410, a first main terminal one (e.g., MT1 terminal 308a) and a first gate terminal (e.g., gate terminal 310a) may be coupled to the first portion (e.g., portion 302a) of the first silicon layer. Similarly, a second main terminal one (e.g., MT1 terminal 308b) and a second gate terminal (e.g., gate terminal 310b) may be coupled to a second portion (e.g., portion 302b) of the first silicon layer. Additionally, a main terminal two (e.g., MT2 terminal 312) may be coupled to third silicon layer 306.

At 412 and 414, one or more regions (e.g., n-type regions) may be formed in the first silicon layers and the third silicon layer, respectively. For example, as shown in FIG. 3, n-type regions 301-305 may be formed in the first portion 302a of the first silicon layer and coupled to the MT1 terminal 308a. Another n-type region 307a may be formed in the first portion 302a of the first silicon layer and coupled to the gate terminal 310a. Yet another n-type region may be formed in the second portion 302b of the first silicon layer and coupled to the gate terminal 310b. No further n-type regions are formed in the second portion 302b of the first silicon layer.

Moreover, n-type regions 309-315, as shown in FIG. 3, may be formed in the third silicon layer 306. The regions 309-315 may be formed in the second portion 318b of the device 300, but not in the first portion 318a. The regions 309-315 may be formed below the terminals 310b and 308b.

As stated above, use of the separate portions of the device 300 accomplished through use of the trench 316 and the isolation region prevents migration of charge carriers from one side to the other, thereby increasing commutability of the device 300. Such commutability enables separate operation modes of the device 300, e.g., the portion 318a may operate when bias of terminal MT2 312 is higher than the bias of terminal MT1 308a, and the portion 318b may operate when bias of terminal MT1 308b is higher than the bias of the terminal MT2 312.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the scope of the appended claims.

The foregoing description has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth of the present disclosure as described herein.

## Claims

1. An apparatus, comprising:
a first silicon layer, a second silicon layer, and a third silicon layer, the first silicon being coupled to the second silicon layer and the second silicon layer being coupled to the third silicon layer;
a trench formed in the first silicon layer and in at least a portion of the second silicon layer;
an isolation region formed in at least the second silicon layer, wherein the isolation region is configured to extend from the trench to the third silicon layer;
a first main terminal one and a first gate terminal coupled to a first portion of the first silicon layer;
a second main terminal one and a second gate terminal coupled to a second portion of the first silicon layer;
a main terminal two coupled to the third silicon layer; and
one or more silicon regions in the first silicon layer and in the third silicon layer.

2. The apparatus according to claim 1, wherein at least one of the first, second and third silicon layers is at least one of the following: an n-type layer, a p-type layer, and any combination thereof, preferably wherein the first silicon layer and the third silicon layers are p-type layers, and the second silicon layer is an n-type layer.

3. The apparatus according to any of the preceding claims, wherein the first and third silicon layers are P+ layers, preferably wherein the second silicon layer is a N- layer.

4. The apparatus according to any of the preceding claims, wherein the one or more silicon regions are n-type regions.

5. The apparatus according to any of the preceding claims with one or more of the following:
• wherein the isolation region is a p-doped region;
• wherein the trench is configured to separate the first silicon layer into the first portion of the first silicon layer and the second portion of the first silicon layer;
• wherein the trench and the isolation region are configured to separate the apparatus into a first apparatus portion and a second apparatus portion.

6. The apparatus according to any of the preceding claims, wherein the first main terminal one and the first gate terminal are each coupled to at least one region in the one or more regions.

7. The apparatus according to any of the preceding claims, wherein the second gate terminal is coupled to at least another region in the one or more regions and the second main terminal one is not coupled to the one or more regions.

8. The apparatus according to any of the claims 5-7, wherein the main terminal two is coupled to at least yet another region in the one or more regions, the at least yet another region being positioned in the third silicon layer in the second apparatus portion.

9. The apparatus according to any of the preceding claims, wherein a depth of the trench is configured to be greater than a thickness of the first silicon layer.

10. The apparatus according to any of the preceding claims 5-9, wherein the trench and the isolation region are configured to prevent migration of one or more charge carriers between the first and second apparatus portions, preferably wherein the first apparatus portion is configured to route current upon a bias of main terminal two being higher than a bias of the first main terminal one, more preferably wherein the second apparatus portion is configured to route current upon a bias of the second main terminal one being higher than a bias of the main terminal two.

11. The apparatus according to any of the preceding claims, wherein the apparatus is a semiconductor device.

12. The apparatus according to claim 11, wherein the semiconductor device is a thyristor.

13. The apparatus according to claim 11 or 12, wherein the semiconductor device is a TRIAC semiconductor device.

14. A semiconductor device, comprising:
a first silicon layer, a second silicon layer, and a third silicon layer, the first silicon being coupled to the second silicon layer and the second silicon layer being coupled to the third silicon layer;
a trench formed in the first silicon layer and in at least a portion of the second silicon layer;
an isolation region formed in at least the second silicon layer, wherein the isolation region is configured to extend from the trench to the third silicon layer, wherein the trench and the isolation region are configured to separate the semiconductor device into a first semiconductor device portion and a second semiconductor device portion;
a first main terminal one and a first gate terminal coupled to a first portion of the first silicon layer;
a second main terminal one and a second gate terminal coupled to a second portion of the first silicon layer;
a main terminal two coupled to the third silicon layer; and
one or more silicon regions in the first silicon layer and in the third silicon layer;
wherein the first semiconductor device portion is configured to route current upon a bias of main terminal two being higher than a bias of the first main terminal one, and the second semiconductor device portion is configured to route current upon a bias of the second main terminal one being higher than a bias of the main terminal two.

15. A method, comprising:
providing a first silicon layer, a second silicon layer, and a third silicon layer;
coupling the first silicon to the second silicon layer and coupling the second silicon layer to the third silicon layer;
forming a trench in the first silicon layer and at least a portion of the second silicon layer;
forming an isolation region in at least the second silicon layer, wherein the isolation region is configured to extend from the trench to the third silicon layer;
coupling a first main terminal one and a first gate terminal to a first portion of the first silicon layer, coupling a second main terminal one and a second gate terminal to a second portion of the first silicon layer, and coupling a main terminal two to the third silicon layer; and
forming one or more regions in the first and second portions of the first silicon layer and the third silicon layer.
